# EUROPEAN PATENT SPECIFICATION

(11) **EP 2 631 938 B1**
(45) Date of publication and mention of the grant of the patent: **01.01.2020**
(21) Application number: 11834110.6
(22) Date of filing: 28.07.2011
(51) Int. Cl.: H01L 21/67, C09J 7/22

(54) **SHEET ADHESION DEVICE AND ADHESION METHOD**
FOLIENHAFTVORRICHTUNG UND -HAFTVERFAHREN
DISPOSITIF D'ADHÉSION DE FEUILLE, ET PROCÉDÉ D'ADHÉSION

(30) Priority: 19.10.2010 JP 2010234750
(43) Date of publication of application: 28.08.2013
(73) Proprietor: LINTEC Corporation, Tokyo 173-0001 (JP)
(72) Inventor: TAKANO Takeshi, Tokyo 173-0001 (JP)
(74) Representative: Hoffmann Eitle
(86) International application number: PCT/JP2011/067197
(87) International publication number: WO 2012/053268

(56) References cited:
- WO-A1-2009/147954
- DE-A1- 19 528 442
- JP-A- S5 578 545
- JP-A- 10 233 430
- JP-A- 2008 159 829
- JP-A- 2008 166 459
- JP-A- 2010 118 584

## Description

The present invention relates to a sheet adhesion device for attaching an adhesive sheet on an adherend and an adhesion method.

In a semiconductor manufacturing process, there has typically been known a sheet adhesion device that attaches a protective sheet and an adhesive sheet such as a mounting sheet, a dicing tape and a die bonding tape on a surface of a semiconductor wafer (i.e., an adherend) (hereinafter, occasionally simply referred to as a wafer) (see, for instance, Patent Literature 1). In this sheet adhesion device, a ring frame on which the adhesive sheet is stuck is held by a frame holder in a chamber and the wafer is positioned above a surface of the adhesive sheet. While the chamber is kept under reduced pressure atmosphere, the wafer is brought into contact with the adhesive sheet, thereby attaching the adhesive sheet on the surface of the wafer.

On the other hand, there has been known a wafer including an annular convex portion projecting in a thickness direction at an outer periphery and a recess surrounded by the convex portion (see, for instance, Patent Literature 2). The wafer is provided by a grinding prior to a dicing in the semiconductor manufacturing process, where a rear surface of the wafer is ground in order to provide a thin semiconductor chip. In the grinding, an inside of the wafer is ground deeper than the outer periphery thereof, so that the inside is formed thinner than the outer periphery.

Herein, "Patent Literature 1" is JP-A-10-233430 and "Patent Literature 2" is JP-A-2007-19461.

However, when an adhesive sheet larger than an outline of the wafer having the convex portion at the outer periphery as disclosed in Patent Literature 2 is stuck on the wafer using a typical sheet adhesion device as disclosed in Patent Literature 1, the adhesive sheet is stuck on the convex portion at the outer periphery of the wafer before being stuck on an entire bottom surface of the recess of the wafer. Accordingly, the adhesive sheet is not stuck at corners of the wafer between an inner circumferential surface and the bottom surface of the recess, so that a gap is created between the adhesive sheet and the wafer.

German patent application publication no. DE 195 28 442 A1 describes a method involving mounting a workpiece and a film to be attached to a main surface of the workpiece, considered to correspond to the preamble of claim 1 below. However, that publication does not disclose the characterising portion of claim 1.

It is therefore desirable to provide a sheet adhesion device capable of attaching an adhesive sheet even to an adherend having a convex portion at an outer periphery with the least formation of gaps, and a sheet adhesion method.

In one aspect, the invention provides a sheet adhesion device, comprising; a sheet adhesion device, comprising: a sheet support unit arranged to support an adhesive sheet positioned to face an adherend, the adhesive sheet being attachable to a ring frame; a sheet deforming unit arranged to bend the supported adhesive sheet toward the adherend to attach the adhesive sheet on the adherend, characterized by a deformation restricting unit arranged to restrict an adhesive sheet region from being deformed toward the adherend, which region is positioned further outward than an outer periphery of the adherend, when the adherend is seen in a planar view, wherein the deformation restricting unit comprises a convex portion arranged to contact with the adhesive sheet, and a recess arranged to contact with the ring frame.

Optionally, the sheet adhesion device further includes a decompression unit that keeps the adherend and the adhesive sheet positioned to face the adherend under reduced pressure atmosphere.

Optionally, the decompression unit forms a first space and a second space on both sides of the adhesive sheet, and the sheet deforming unit bends the adhesive sheet toward the adherend by a difference in pressures in the first space and the second space to attach the adhesive sheet on the adherend.

In another aspect, the invention provides a sheet adhesion method, comprising: supporting an adhesive sheet, positioned to face an adherend by contacting a ring frame with a recess of a deformation restricting unit, the ring frame being restrictable to the adhesive sheet, contacting a region of the adhesive sheet with a convex portion of the deformation restricting unit; bending the supported adhesive sheet toward the adherend to attach the adhesive sheet on the adherend, restricting an adhesive sheet region from being deformed toward the adherend by the convex portion of the deformation restricting unit, which region is positioned further outward than an outer periphery of the adherend, when seen in a planar view.

In order that the invention will be more readily understood, embodiments thereof will now be described, by way of example only, and background examples, with reference to the drawings, and in which:-
Fig. 1 is a side elevational partial cross section of a sheet adhesion device according to an exemplary embodiment of the invention;
Fig. 2 illustrates an operation of the sheet adhesion device;
Fig. 3 illustrates an operation of the sheet adhesion device;
Fig. 4 illustrates an operation of the sheet adhesion device;
Fig. 5 illustrates an operation of the sheet adhesion device; and
Fig. 6 is a side elevational partial cross section of a sheet adhesion device in which a part of components is replaced.

According to the embodiments of invention, when the adhesive sheet is bent toward the adherend to be stuck thereon, the adhesive sheet region positioned further outward than the outer periphery of the adherend can be restricted from being bent toward the adherend. Accordingly, even when the adherend is provided by, for instance, a wafer having a convex portion at the outer periphery and a recess in the middle, the adhesive sheet can be stuck over a wide range of a bottom surface of the recess of the wafer before being stuck on the convex portion of the wafer. Consequently, the adhesive sheet can be stuck with the least formation of gaps.

A decompression unit is provided that keeps the adherend and the adhesive sheet positioned to face the adherend under reduced pressure atmosphere, the adhesive sheet can be stuck on the adherend under reduced pressure and formation of a gap between the adhesive sheet and the adherend can be prevented.

Moreover, in the first space and the second space independently formed on both sides of the adhesive sheet, when pressure in the first space is higher than pressure in the second space, the adhesive sheet is bent toward the adherend because of a difference between the pressures in the first and second spaces. Accordingly, since the adhesive sheet can be stuck on the adherend from the middle area toward the outer periphery, the adhesive sheet can be prevented from being initially stuck on the outer periphery of the adherend.

An exemplary embodiment of the invention will be described below with reference to the attached drawings.

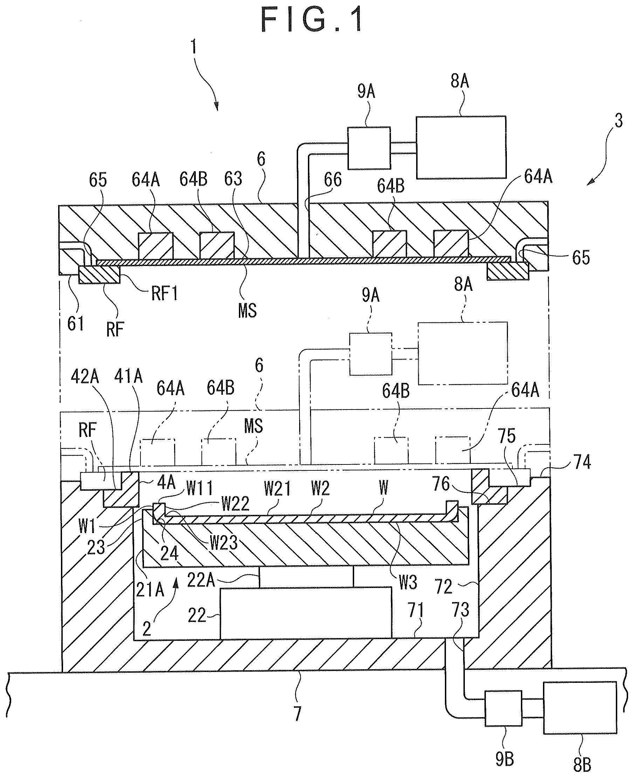

As shown in Fig. 1, a sheet adhesion device 1 according to the exemplary embodiment attaches on a wafer W (an adherend) a mounting sheet MS (an adhesive sheet), which is previously stuck over an opening RF1 of a ring frame RF in a manner to close the opening RF1, whereby the wafer W and the ring frame RF are united by the mounting sheet MS. Herein, the wafer W is a semiconductor wafer having a rear surface and a front surface. On the rear surface, an annular convex portion W1 projecting in a thickness direction (from the rear surface) is formed by grinding the rear surface such that an outer periphery becomes thicker than portions other than the outer periphery, while a recess W2 is formed at an inner area surrounded by the convex portion W1. On the front surface (opposite to a ground surface: a lower surface of the wafer W in Fig. 1), namely, on a circuit surface W3, a circuit is formed. A protective sheet (not shown) is stuck on the circuit surface W3. The mounting sheet MS includes: a base sheet (not shown); and an adhesive layer laminated on a surface of the base sheet.

In Fig. 1, the sheet adhesion device 1 can attach the mounting sheet MS on the wafer W in plural sizes by replacing a later-described table 21A with a table different in size from the table 21A. Accordingly, for instance, a sheet adhesion device 1 for an 203mm (8-inch) frame can attach the mounting sheet MS on a 152mm (6-inch) wafer W and a 203mm (8-inch) wafer W, and a sheet adhesion device 1 for a 305mm (12-inch) frame can attach the mounting sheet MS on a 203mm (8-inch) wafer W and a 305mm (12-inch) wafer W.

The sheet adhesion device 1 includes: an adherend support unit 2 that supports the wafer W; a decompression unit 3 that positions the mounting sheet MS to face the wafer W and keeps the wafer W and the mounting sheet MS under reduced pressure atmosphere; and a deformation restricting member 4A (i.e., a deformation restricting unit) that restricts a region of the mounting sheet MS positioned further outward than the outer periphery of the wafer W when the wafer W is seen in a planar view from being deformed toward the wafer W.

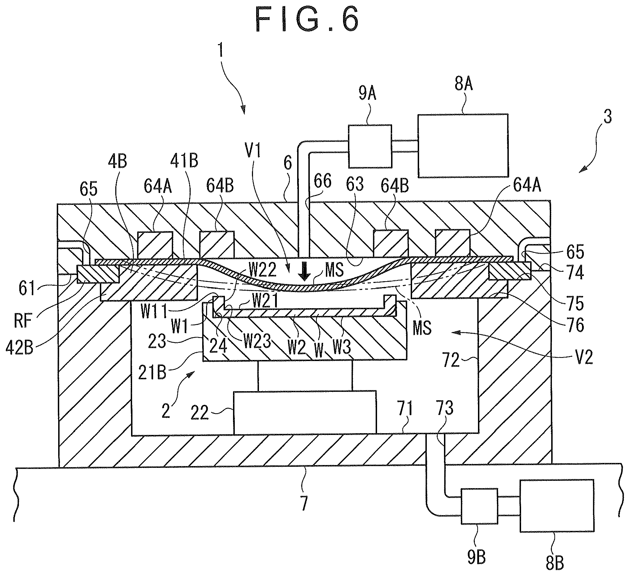

The adherend support unit 2 includes: the disc-like table 21A having an outline larger than the outer periphery of the wafer W; and a linear movement motor 22 (a driving device) having an output shaft 22A fixed to a lower surface of the table 21A. An annular convex portion 23 provided by projecting an outer periphery of the table 21A in a thickness direction (upward in Fig. 1) is provided on an upper surface 24 of the table 21A. In the adherend support unit 2, the table 21A is replaceable with a table 21B (see Fig. 6) different in size from the table 21A in order to support the wafer W in plural sizes.

For instance, the adherend support unit 2 for a 305mm (12-inch) wafer W is shown in Fig. 1 and the adherend support unit 2 for a 203mm (8-inch) wafer W is shown in Fig. 6.

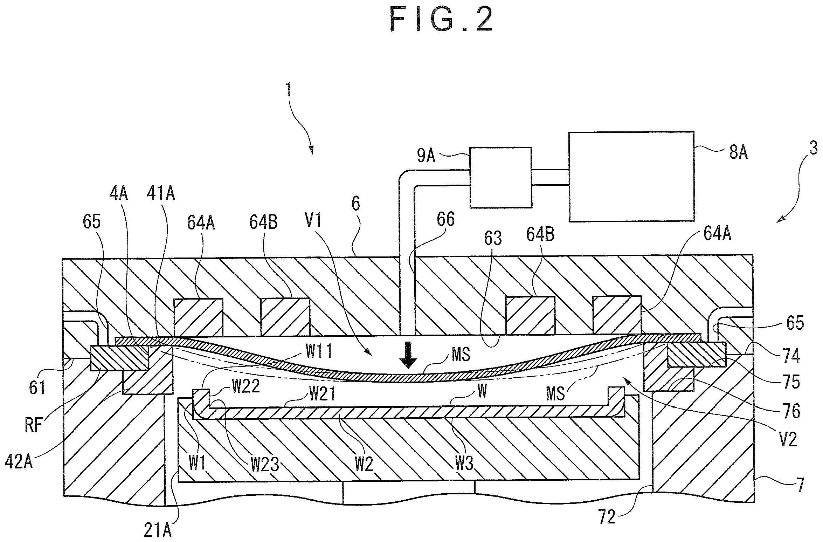

The decompression unit 3 includes: a cover member 6 and a lower chamber 7 (i.e., sheet support units) that support the mounting sheet MS stuck on the ring frame RF such that the mounting sheet MS faces the wafer W; a pressure adjuster 8A (i.e., a sheet deforming unit) that can reduce pressure in a first space V1 (see Fig. 2) defined by the cover member 6 and the mounting sheet MS; and a pressure adjuster 8B (i.e., a sheet deforming unit) that can reduce pressure in a second space V2 (see Fig. 2) defined by the mounting sheet MS and the lower chamber 7.

The cover member 6 is movable up and down by a driving device (not shown). On a lower surface 61 of the cover member 6, there are provided a frame holder 63 having the same outline as that of the ring frame RF and a recessed cross section, and annular elastic members 64A and 64B buried in the frame holder 63 while a surface of each of the elastic members 64A and 64B is exposed. A part of the frame holder 63 underneath which the ring frame RF is positioned includes a plurality of suction holes 65 and is made of an elastic member so as to conform to a step formed by the mounting sheet MS, thereby ensuring sealability of the first space V1. The frame holder 63 includes a pressure adjustment channel 66 connected to the pressure adjuster 8A. The pressure adjustment channel 66 includes a pressure detector 9A that detects the pressure in the first space V1.

The lower chamber 7 is formed in a box shape with an open upper surface 74. Specifically, the lower chamber 7 includes a bottom surface 71 on which the adherend support unit 2 is provided; and a lateral surface 72 that extends upward from an outer periphery of the bottom surface 71. A pressure adjustment channel 73 connected to the pressure adjuster 8B is provided on the bottom surface 71. A pressure detector 9B that detects the pressure in the second space V2 is provided in the pressure adjustment channel 73. On the upper surface 74 of the lateral surface 72, there are provided an annular frame support 75 formed one step lower than the upper surface 74 near an inner circumference of the lateral surface 72, and a restricting member support 76 formed one step lower than the frame support 75 and inside the inner circumference of the frame support 75. The ring frame RF on which the mounting sheet MS is stuck is supported by the frame support 75. The deformation restricting member 4A is supported by the restricting member support 76.

In the decompression unit 3, the first space V1 and the second space V2 are independently defined on both sides of the mounting sheet MS. The pressure adjusters 8A and 8B adjust the pressures in the first and second spaces V1 and V2, thereby pressing the mounting sheet MS by a difference between the pressures in the first and second spaces V1 and V2 to attach the mounting sheet MS on the wafer W.

The deformation restricting member 4A is an annular member having an L-shaped cross section. Specifically, the deformation restricting member 4A includes: an annular convex portion 41A projecting in a thickness direction and provided at an inner periphery; and a recess 42A joined to an outer periphery of the convex portion 41A. The deformation restricting member 4A is supported by the restricting member support 76 of the lower chamber 7 while the convex portion 41A faces the mounting sheet MS. When the lower surface 61 of the cover member 6 is in contact with the upper surface 74 of the lower chamber 7, the convex portion 41A is in contact with the mounting sheet MS and the recess 42A is in contact with the ring frame RF. A contact surface of the convex portion 41A to be in contact with the mounting sheet MS is laminated with a fluorine resin and the like for non-adhesion treatment so that the stuck mounting sheet MS is peelable.

In the above sheet adhesion device 1, a procedure for attaching the mounting sheet MS on the wafer W will be described.

Initially, using a delivery unit (not shown), a ring frame RF for a 305mm (12-inch) wafer with the opening RF1 closed by the mounting sheet MS as shown in Fig. 1 is sucked and held by the cover member 6, while the 305mm (12-inch) wafer W is mounted on the table 21A for a 305mm (12-inch) wafer as shown in Fig. 1. Subsequently, the decompression unit 3 lowers the cover member 6 using a driving device (not shown) and brings the lower surface 61 of the cover member 6 into contact with the upper surface 74 of the lower chamber 7. After the first and second spaces V1 and V2 (see Figs. 2-4) are defined by the cover member 6 and the lower chamber 7, the pressure adjusters 8A and 8B vacuumize or decompress the first and second spaces V1 and V2 under equal pressure while decompressing the first and second spaces V1 and V2 by the same decompression ratio.

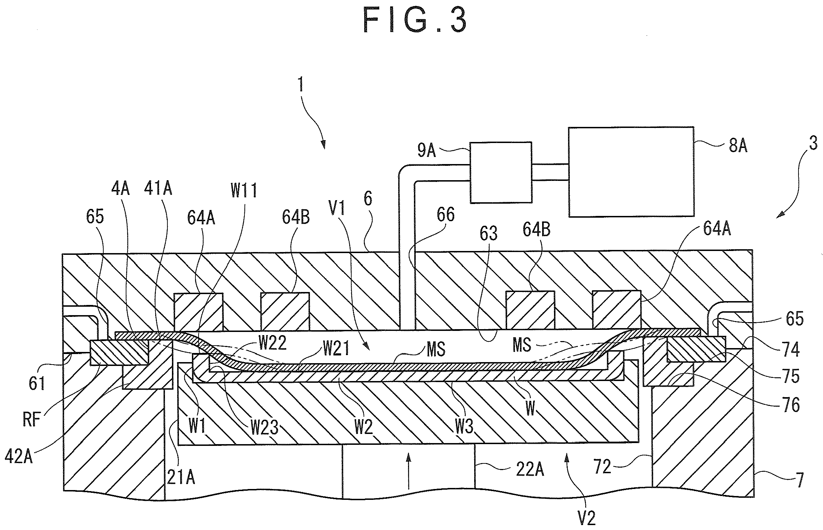

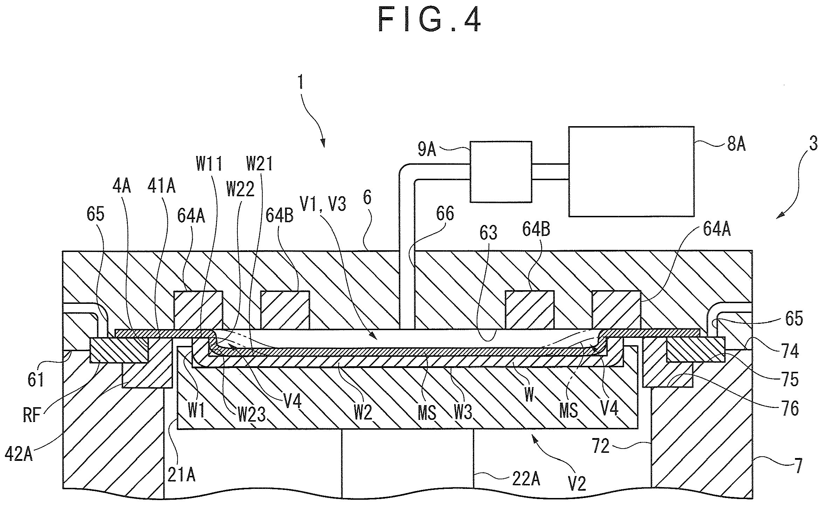

Next, the decompression unit 3 sets the pressure in the first space V1 higher than 5 the pressure of the second space V2 using the pressure adjusters 8A and 8B while keeping the decompression of the first and second spaces V1 and V2. Accordingly, as shown in Fig. 2, the mounting sheet MS is pressed toward the second space V2 by the difference in pressure between the first and second spaces V1 and V2 and is bent such that a middle of the mounting sheet MS comes closest to the wafer W. Under this condition, when the linear movement motor 22 is driven to raise the table 21A, the mounting sheet MS is gradually stuck on the wafer W from the middle of the wafer W toward the outer periphery thereof, as shown in Fig. 3. As shown in Fig. 4, when the mounting sheet MS is kept being pressed onto the elastic member 64A of the cover member 6 by a top surface W11 of the convex portion W1, a third space V3 is created between an inner side of the elastic member 64 and the mounting sheet MS in the first space V1, while a fourth space V4 (gap) is created between the mounting sheet MS and the wafer W in the second space V2.

Herein, the mounting sheet MS having such a size as extends beyond the outer periphery of the wafer W is previously stuck on the opening RF1 of the ring frame RF and is supported by the cover member 6 and the lower chamber 7 via the ring frame RF. Specifically, the mounting sheet MS, which is positioned to face the wafer W, is supported by the cover member 6 and the lower chamber 7 at a position further outward than the outer periphery of the wafer W and spaced away from the outer periphery of the wafer W. Accordingly, in an arrangement, according to a background example, without the deformation restricting member 4A, since a part of the mounting sheet MS corresponding to the ring frame RF positioned further outward than the outer periphery of the wafer W is initially bent as shown by a chain double-dashed line in Fig. 2, the mounting sheet MS becomes stuck on a top surface W11 of the convex portion W1 of the wafer W before the mounting sheet MS is stuck over a broad area covering from a middle of the recess W2 to a bottom surface W21 of the wafer W. Even when air is introduced into the first space V1 to act on the mounting sheet MS under this condition, the fourth space V4 cannot be eliminated but left as shown by a chain double-dashed line in Fig. 4. No fourth space V4 is left when the first and second spaces V1 and V2 are decompressed into a perfect vacuum (non-pressure condition). However, it is technically difficult to bring the first and second spaces V1 and V2 into a perfect vacuum. Moreover, a decompression device for bringing the first and second spaces V1 and V2 closer to a perfect vacuum becomes large in size and it takes considerable time to decompress the first and second spaces V1 and V2 into such a condition. Accordingly, a typical decompression device used in an industrial apparatus cannot bring the first and second spaces V1 and V2 into a perfect vacuum or closer thereto.

On the other hand, in an arrangement, according to an embodiment of the invention, with the deformation restricting member 4A, a region of mounting sheet MS, which is positioned further outward than the outer periphery of the wafer W when the wafer W is seen in a planar view, is contacted with the convex portion 41A of the deformation restricting member 4A, whereby the deformation restricting member 4A restricts the region of the mounting sheet MS from being deformed toward the wafer W. With this arrangement, the region of the mounting sheet MS positioned further outward than the outer periphery of the wafer W can be restricted from being deformed and prevented from being bent toward the wafer W. Accordingly, as compared with the arrangement without the deformation restricting member 4A, since a region where the mounting sheet MS is stuck on the bottom surface W21 of the recess W2 before being stuck on the top surface W11 of the convex portion W1 can be broadened, the fourth space V4 can be as small as possible.

Subsequently, the pressure adjuster 8B sets the pressure in the second space V2 at a pressure equal to the pressure in the first space V1. Next, the decompression unit 3 gradually returns the pressures in the third and second spaces V3 and V2 to the atmospheric pressure while increasing the pressures in the third and second spaces V3 and V2 at the same pressure-increasing ratio using the pressure adjusters 8A and 8B, whereby the fourth space V4 is pressed by the pressure in the third space V3 through the mounting sheet MS to gradually become smaller. Consequently, the mounting sheet MS is stuck on a corner W23 of the wafer W completely in close contact with the corner W23. Strictly speaking, the mounting sheet MS is not in close contact with the corner W23 of the wafer W. However, since the fourth space V4 in the decompression state is formed as small as possible, the mounting sheet MS appears to be in close contact with the corner W23 of the wafer W.

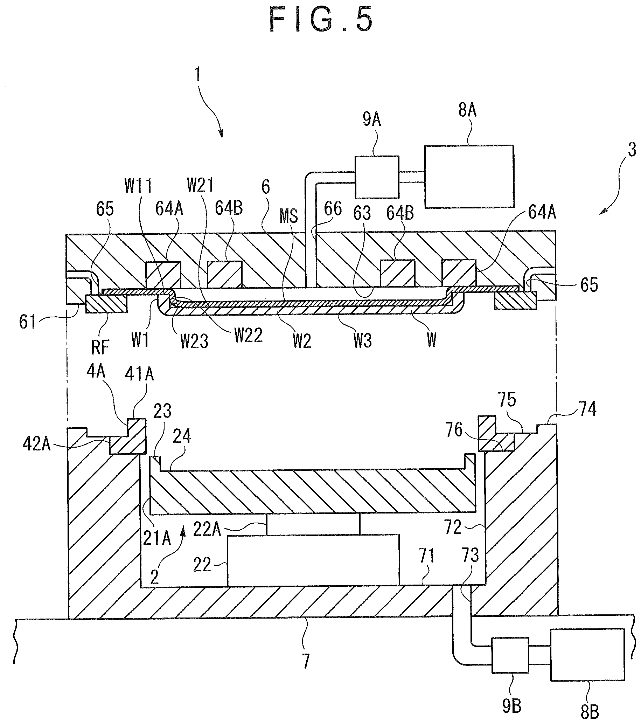

After the attaching of the mounting sheet MS is completed as described above and the wafer W and the ring frame RF are united through the mounting sheet MS, the cover member 6 is raised to a predetermined position using a driving device (not shown) while the cover member 6 sucks and holds the ring frame RF through the suction holes 65 as shown in Fig. 5. Subsequently, the delivery unit (not shown) delivers the wafer W and the ring frame RF to a next step, for instance, a peeling step of the protective sheet and the like.

On the other hand, when a wafer W of a different size is mounted on the ring frame RF, for instance, a 203mm (8-inch) wafer W is mounted on the ring frame RF for a 305mm (12-inch) wafer through the mounting sheet MS, the table 21A for the 305mm (12-inch) wafer is replaced with the table 21B for the 203mm (8-inch) wafer and the deformation restricting member 4A is replaced with a deformation restricting member 4B matching the table 21A in size as shown in Fig. 6. Specifically, when the table 21B is smaller than the table 21A, the deformation restricting member 4B having the same outer diameter, the same recess 42B in size, a smaller inner diameter, and a convex portion 41B having a longer radial length, as compared with the deformation restricting member 4A is used. With this arrangement, even when the small table 21B matching a small wafer is used, deformation of the region further outward than the outer periphery of the wafer W of the mounting sheet MS is restricted, so that the region of the mounting sheet MS is prevented from being bent toward the wafer W.

The mounting sheet MS is stuck on the wafer W in the same manner as described above. Thus, even when the small wafer W is used, the mounting sheet MS can be stuck on the wafer W visually without creating the fourth space V4 between the mounting sheet MS and the wafer W.

According to the above-described exemplary embodiment, the following advantages can be obtained.

Since the sheet adhesion device 1 restricts the region of the mounting sheet MS further outward than the outer periphery of the wafer W from being deformed toward the wafer W when the region of the mounting sheet MS is bent toward the wafer W to be stuck on the wafer W, the sheet adhesion device 1 can restrict the region of the mounting sheet MS from being bent toward the wafer W. Accordingly, since the mounting sheet MS can be stuck over a broad range of the bottom surface W21 of the recess W2 of the wafer W before the mounting sheet MS is stuck on the top surface W11 of the convex portion W1 at the outer periphery of the wafer W, generation of the fourth space V4 between the mounting sheet MS and the wafer W can be prevented.

Although the best embodiments of the invention has been disclosed above, the invention is not limited thereto. In other words, while embodiments of the invention have been described and illustrated in the drawings, various modifications may be made on shapes, materials, quantities and other specific configurations to the disclosed exemplary embodiments by those of ordinary skill in the art without departing from the scope of the claimed invention. The description limiting the shapes and the materials disclosed above is intended to be illustrative for easier understanding and not to limit the scope of the invention, hence the claimed invention includes within its scope the description using a name of component without a part of or all of the limitation on the shape and the material etc. The scope of the invention is defined by the appended claims.

For instance, in the above exemplary embodiment, the adherend is exemplified by the wafer W. However, the adherend is not limited to the wafer W and the ring frame RF is not requisite. In addition to the wafer W, not only a glass plate, steel plate, resin plate and other plate-like members, but also articles other than the plate-like members may be used as the adherend. The wafer W is exemplified by a silicon semiconductor wafer and a compound semiconductor wafer. An adhesive sheet to be stuck on such an adherend is not limited to the mounting sheet MS, but any other sheet, film, tape and the like, and an adhesive sheet having any shape for any application to be stuck on a plate-like member may be applicable. In the above exemplary embodiment, the wafer W in which the protective sheet is stuck on the circuit surface is employed. However, a wafer W without a protective sheet thereon may be employed.

In the above exemplary embodiment, the mounting sheet MS stuck on the ring frame RF is supported by the cover member 6 and the lower chamber 7 of the decompression unit 3. However, the sheet support unit is not limited to the cover member 6 and the lower chamber 7. For instance, the cover member 6 may be formed in a box shape like the lower chamber 7. A table for supporting the ring frame RF and the mounting sheet MS may be provided on the lower surface 61 of the cover member 6, while an outer circumference table may be provided on the bottom surface 71 of the lower chamber 7 in a manner to surround the adherend support unit 2. Thus, the above tables may support the mounting sheet MS stuck on the ring frame RF.

In the above exemplary embodiment, the cover member 6 and the lower chamber 7 hold the wafer W and the mounting sheet MS by holding the ring frame RF. However, the cover member 6 and the lower chamber 7 may hold the mounting sheet MS.

In the above exemplary embodiment, the mounting sheet MS is bent toward the wafer W using the pressure adjuster 8A by setting the pressure in the first space V1 without the wafer W higher than the pressure in the second space V2 with the wafer W. However, the sheet deforming unit for bending the mounting sheet MS toward the wafer W is not limited thereto. For instance, the pressure in the second space V2 may be set lower than the pressure in the first space V1 using the pressure adjuster 8B. Alternatively, a attaching roller may be provided and may be rolled over the mounting sheet MS, whereby the mounting sheet MS may be bent toward the wafer to be stuck on the wafer W.

In the above exemplary embodiment, the annular deformation restricting member 4A is provided. However, the deformation restricting unit is not limited thereto. In other words, it is only required that the region of the mounting sheet MS further outward than the outer periphery of the wafer W is restricted from being deformed toward the wafer W. For instance, a plurality of suction holes may be provided at a part of the cover member 6 further outward than the outer periphery of the wafer W. The region of the mounting sheet MS further outward than the outer periphery of the wafer W may be restricted from being deformed toward the wafer W by the mounting sheet MS being sucked through the suction holes in a direction opposite to a direction toward the wafer W.

The driving device in the above exemplary embodiments may be provided by: motorized equipment such as a rotary motor, linear movement motor, linear motor, single-spindle robot and multi-joint robot; an actuator such as an air cylinder, hydraulic cylinder, rodless cylinder and rotary cylinder; and a direct or indirect combination thereof (some of the driving devices overlap with the exemplified driving devices in the exemplary embodiments).

### EXPLANATION OF CODES

1: sheet adhesion device
3: decompression unit
4A,4B: deformation restricting member (deformation restricting unit)
6: cover member (sheet support unit)
7: lower chamber (sheet support unit)
8A,8B: pressure adjuster (sheet deforming unit)
MS: mounting sheet (adhesive sheet)
V1: first space
V2: second space
W: wafer (adherend)

## Claims

1. A sheet adhesion device (1), comprising:
a sheet support unit (6, 7) arranged to support an adhesive sheet positioned to face an adherend (W), the adhesive sheet being attachable to a ring frame (RF);
a sheet deforming unit (8A) arranged to bend the supported adhesive sheet toward the adherend to attach the adhesive sheet on the adherend,
**characterized in that** the sheet adhesion device further comprises a deformation restricting unit (4A, 4B) arranged to restrict an adhesive sheet region from being deformed toward the adherend, which region is positioned further outward than an outer periphery of the adherend, when the adherend is seen in a planar view, wherein the deformation restricting unit comprises a convex portion (41A,41B) arranged to contact with the adhesive sheet, and a recess (42A,42B) arranged to contact with the ring frame.

2. The sheet adhesion device according to claim 1, further comprising a decompression unit (3) arranged to keep the adherend and the adhesive sheet positioned to face the adherend under reduced pressure atmosphere.

3. The sheet adhesion device according to claim 2, wherein:
the decompression unit is arranged to form a first space (V1) and a second space (V2) on both sides of the adhesive sheet; and
the sheet deforming unit is arranged to bend the adhesive sheet toward the adherend by a difference in pressures in the first space and the second space to attach the adhesive sheet on the adherend.

4. The sheet adhesion device of any preceding claim, wherein the sheet support unit comprises an annular frame support (75) arranged to support the ring frame, and a restricting member support (76) formed inside an inner circumference of the annular frame support and supporting the deformation restricting unit.

5. A sheet adhesion method, comprising:
supporting an adhesive sheet (MS), positioned to face an adherend (W), by contacting a ring frame (RF) with a recess (42A,42B) of a deformation restricting unit (4A, 4B), the ring frame being stickable to the adhesive sheet (MS), contacting a region of the adhesive sheet with a convex portion (41A,41B) of the deformation restricting unit;
bending the supported adhesive sheet toward the adherend to attach the adhesive sheet on the adherend, restricting an adhesive sheet region from being deformed toward the adherend by the convex portion of the deformation restricting unit, which region is positioned further outward than an outer periphery of the adherend, when seen in a planar view.

## Patentansprüche

1. Folienklebevorrichtung (1), umfassend:
eine Folientrageinheit (6, 7), die dazu angeordnet ist, eine Klebefolie zu tragen, die positioniert ist, um einer Klebefläche (W) zugewandt zu sein, wobei die Klebefolie an einem Ringrahmen (RF) befestigt werden kann;
eine Folienverformungseinheit (8A), die dazu angeordnet ist, die getragene Klebefolie in Richtung der Klebefläche zu biegen, um die Klebefolie an der Klebefläche zu befestigen,
**dadurch gekennzeichnet, dass** die Folienklebevorrichtung weiter umfasst
eine Verformungsbeschränkungseinheit (4A, 4B), die dazu angeordnet ist, ein Verformen einer Klebefolienregion in Richtung der Klebefläche zu beschränken, wobei die Region weiter außen als ein Außenumfang der Klebefläche positioniert ist, wenn die Klebefläche in einer Draufsicht betrachtet wird, wobei die Verformungsbeschränkungseinheit einen konvexen Abschnitt (41A, 41B), der dazu angeordnet ist, die Klebefolie zu berühren, und eine Aussparung (42A, 42B) umfasst, die dazu angeordnet ist, den Ringrahmen zu berühren.

2. Folienklebevorrichtung nach Anspruch 1, weiter umfassend eine Dekompressionseinheit (3), die dazu angeordnet ist, die Klebefläche und die Klebefolie so positioniert zu halten, dass sie der Klebefläche unter einer Unterdruckatmosphäre zugewandt ist.

3. Folienklebevorrichtung nach Anspruch 2, wobei:
die Dekompressionseinheit dazu angeordnet ist, einen ersten Raum (V1) und einen zweiten Raum (V2) auf beiden Seiten der Klebefolie auszubilden; und
die Folienverformungseinheit dazu angeordnet ist, die Klebefolie durch eine Differenz der Drücke im ersten Raum und im zweiten Raum in Richtung der Klebefläche zu biegen, um die Klebefolie an der Klebefläche zu befestigen.

4. Folienklebevorrichtung nach einem der vorhergehenden Ansprüche, wobei die Folientrageinheit einen ringförmigen Rahmenträger (75), der dazu angeordnet ist, den Ringrahmen zu tragen, und einen Beschränkungselementträger (76) umfasst, der innerhalb eines Innenumfangs des ringförmigen Rahmenträgers ausgebildet ist und die Verformungsbeschränkungseinheit trägt.

5. Folienklebeverfahren, umfassend:
Tragen einer Klebefolie (MS), die positioniert ist, um einer Klebefläche (W) zugewandt zu sein, durch Berühren eines Ringrahmens (RF) mit einer Aussparung (42A, 42B) einer Verformungsbeschränkungseinheit (4A, 4B),
wobei der Ringrahmen an die Klebefolie (MS) geklebt werden kann, wodurch eine Region der Klebefolie durch einen konvexen Abschnitt (41A, 41B) der Verformungsbeschränkungseinheit berührt wird;
Biegen der getragenen Klebefolie in Richtung der Klebefläche, um die Klebefolie an der Klebefläche zu befestigen, wobei durch den konvexen Abschnitt der Verformungsbeschränkungseinheit beschränkt wird, dass eine Klebefolienregion in Richtung der Klebefläche verformt wird, wobei die Region weiter außen als ein Außenumfang der Klebefläche positioniert ist, wenn sie in einer Draufsicht betrachtet wird.

## Revendications

1. Dispositif d'adhésion de feuille (1), comprenant :
une unité de support de feuille (6, 7) agencée pour supporter une feuille adhésive positionnée de façon à faire face à un support à coller (W), la feuille adhésive pouvant être fixée à un cadre annulaire (RF) ;
une unité de déformation de feuille (8A) agencée pour plier la feuille adhésive supportée en direction du support à coller pour fixer la feuille adhésive sur le support à coller,
**caractérisé en ce que** le dispositif d'adhésion de feuille comprend en outre
une unité de limitation de déformation (4A, 4B) agencée pour empêcher une région de feuille adhésive d'être déformée en direction du support à coller, laquelle région est positionnée davantage vers l'extérieur qu'une périphérie externe du support à coller, lorsque le support à coller est observé dans une vue en plan, dans lequel l'unité de limitation de déformation comprend une partie convexe (41A, 41B) agencée pour venir en contact avec la feuille adhésive, et un évidement (42A, 42B) agencé pour venir en contact avec le cadre annulaire.

2. Dispositif d'adhésion de feuille selon la revendication 1, comprenant en outre une unité de décompression (3) agencée pour maintenir le support à coller et la feuille adhésive positionnée pour faire face au support à coller sous une atmosphère à pression réduite.

3. Dispositif d'adhésion de feuille selon la revendication 2, dans lequel :
l'unité de décompression est agencée pour former un premier espace (V1) et un deuxième espace (V2) de part et d'autre de la feuille adhésive ; et
l'unité de déformation de feuille est agencée pour plier la feuille adhésive en direction du support à coller par une différence des pressions dans le premier espace et le deuxième espace pour fixer la feuille adhésive sur le support à coller.

4. Dispositif d'adhésion de feuille selon l'une quelconque revendication précédente, dans lequel l'unité de support de feuille comprend un support de cadre annulaire (75) agencé pour supporter le cadre annulaire, et un support d'élément de limitation (76) formé à l'intérieur d'une circonférence interne du support de cadre annulaire et supportant l'unité de limitation de déformation.

5. Procédé d'adhésion de feuille, comprenant :
le support d'une feuille adhésive (MS), positionnée pour faire face à un support à coller (W), par mise en contact d'un cadre annulaire (RF) avec un évidement (42A, 42B) d'une unité de limitation de déformation (4A, 4B), le cadre annulaire pouvant coller à la feuille adhésive (MS), mettant en contact une région de la feuille adhésive avec une partie convexe (41A, 41B) de l'unité de limitation de déformation ;
le pliage de la feuille adhésive supportée en direction du support à coller pour fixer la feuille adhésive sur le support à coller, en empêchant une région de feuille adhésive d'être déformée en direction du support à coller par la partie convexe de l'unité de limitation de déformation, laquelle région est positionnée davantage vers l'extérieur qu'une périphérie externe du support à coller, lorsqu'on observe dans une vue en plan.
